# EUROPEAN PATENT APPLICATION

(11) **EP 1 713 130 A1**
(43) Date of publication of application: **18.10.2006**
(21) Application number: 05709770.1
(22) Date of filing: 04.02.2005
(51) Int. Cl.: H01L 29/861, H01L 29/06, H01L 29/74, H01L 29/744, H01L 29/78

(54) **HIGH BREAKDOWN VOLTAGE WIDE GAP SEMICONDUCTOR DEVICE AND POWER DEVICE**

(30) Priority: 06.02.2004 JP 2004031214
(71) Applicant: THE KANSAI ELECTRIC POWER CO., INC., Osaka-shi, Osaka 530-8270 (JP)
(72) Inventor: SUGAWARA, Yoshitaka, The Kansai Elect Power Co Inc, Osaka-shi, Osaka, 5308270 (JP)
(74) Representative: Suckling, Andrew Michael
(86) International application number: PCT/JP2005/001705
(87) International publication number: WO 2005/076369

(57) **Abstract**

A semiconductor device with high withstand voltage, reduced forward-direction voltage degradation, long lifetime and high reliability, is provided. A junction between the drift layer and anode layer of a bipolar semiconductor device and an electric field relaxation layer are formed at a distance from each other, and an edge portion of the anode is opposed to the semiconductor region between the junction and the electric field relaxation layer, with an insulating film intervening. When reverse-biased, due to the electric field effect imparted to the drift layer between the junction and the electric field relaxation layer from the electrode, with the insulating film intervening, the junction and electric field relaxation layer are electrically connected, and electric field concentration at the junction edge portion is relaxed. When forward-biased, the junction and electric field relaxation layer are electrically isolated, and forward-direction current flows only through the junction.

## Description

### TECHNICAL FIELD

This invention relates to a wide-gap semiconductor device, and in particular relates to a high-withstand voltage wide-gap semiconductor device having a high withstand voltage, and to a power device having this semiconductor device.

### BACKGROUND ART

Silicon carbide (SiC) and other wide-gap semiconductor materials have excellent characteristics, including a dielectric breakdown electric field intensity which is approximately ten times higher than for silicon (Si), and so are attracting attention as materials suitable for high-withstand voltage power semiconductor devices having high withstand-voltage characteristics.

PIN diodes, bipolar transistors, GTOs and other bipolar semiconductor devices using wide-gap semiconductor materials have higher built-in voltages than that of unipolar semiconductor devices such as Schottky diodes and MOSFETs. Moreover, because the turn-on resistance is greatly reduced due to conductivity modulation in the drift layer due to minority carrier injection, losses are small. For these reasons, bipolar semiconductor devices are widely used in power applications and other areas in which high voltages and large currents are handled, in order to reduce losses. When comparing SiC bipolar semiconductor devices with Si bipolar semiconductor devices, for example, a SiC PIN diode has a forward-direction voltage which is approximately 1/3 that of an Si PIN diode in the case of a 10 kV high-withstand voltage device, and fast turn-off operation with a reverse recovery time of approximately 1/20 or less. For these reasons, the power losses in a SiC PIN diode are reduced to approximately 1/5 or less than those of Si, greatly contributing to energy conservation. In addition to SiC PIN diodes, SiC NPN transistors, SiC SIAFETs, SiC SIJFETs, SiC IGBTs, and other devices are being developed, and the effect in reducing power losses is reported to be substantial in all these cases (see for example Non-Patent Reference 1). As the drift layer, SiC GTOs using p-type semiconductor layers with polarity opposite that of PIN diodes and other devices are also being developed (see for example Non-Patent Reference 2).

In order to achieve a high withstand voltage in a SiC bipolar semiconductor device, it is necessary to relax the electric field concentration at the edges of the pn junction (hereafter called the main junction) forming the active region, which is the main path of the current flowing in the bipolar semiconductor device. In order to relax this electric field concentration in a conventional SiC bipolar semiconductor device, an electric field relaxation region and electric field relaxation layer are provided in contact with the edges of the main junction. A conventional SiC PIN diode having a field relaxation layer is explained referring to Fig. 7.

Fig. 7 is a cross-sectional view of a planar high-withstand voltage PIN diode, shown in Non-Patent Reference 3. In the figure, a drift layer 105 is formed by epitaxial growth of p⁻-type SiC semiconductor on the upper surface of the substrate 103 (anode region), of p⁺-type SiC semiconductor having an anode 101 on the lower surface. Ion implantation is used to form an n⁺-type SiC semiconductor cathode region 109 in the center portion of the drift layer 105. Further, an n-type SiC semiconductor JTE (Junction Termination Extension) layer 107 is provided in contact with the two edge portions 112 of the cathode region 109, acting as field relaxation layers. The junction portion between the cathode region 109 and the drift layer 105 is the main junction 110. A cathode electrode 113 is provided in contact with the cathode region 109, and a surface protective film 111 is provided on the remaining surface. It is preferable that the JTE layer 107 have a lower impurity concentration than the cathode region 109; when the concentrations are the same, the thickness is made greater than that of the cathode region 109.

When a reverse-direction voltage is applied to this PIN diode, the electric field is concentrated at the junction edge portions 106 of the JTE layer 107. However, the JTE layer 107 has a lower concentration, or is thicker than, the edge portions 112 of the main junction 110, and so the field concentration is suppressed, and the electric field value can be kept low. By this means, the applied voltage at which the value of the electric field at the junction edge portions 106 reaches the dielectric breakdown field can be made high, so that a high withstand voltage can be obtained.

As another method, a field relaxation layer which is called a RESURF (reduced surface field) by practitioners of the art can be employed. A layer with concentration still lower than that of the JTE layer 107 is provided on the edge portions of the main junction 110, and when a reverse voltage is applied, the depletion layer broadens into the RESURF as well. When a reverse voltage close to the withstand voltage is applied, substantially all of the RESURF is depleted, the electric field within the RESURF becomes substantially uniform, and the RESURF accounts for a portion of the applied voltage. By this means, the electric field concentration in the main junction 110 and the vicinity thereof can be relaxed, and a high withstand voltage is obtained.

Non-Patent Reference 1: Hiroyuki Matsunami, "Semiconductor SiC Technology and Applications", Nikkan Kogyo Shimbunsha, March 31 2003, pp. 218-221.

Non-Patent Reference 2: A.K. Agarwal et al, Materials Science Forum, Vol. 389-393, 2002, pp. 1349-1352.

Non-Patent Reference 3: K. Chatty et al, Materials Science Forum, Vol. 338-342, 2000, pp. 1331-1334.

### DISCLOSURE OF THE INVENTION

### PROBLEMS TO BE SOLVED BY THE INVENTION

As has been reported in the Materials Science Forum published in 2002, Vol. 389-393, pp. 1259-1264, with increasing current passage time (usage time) of a wide-gap bipolar semiconductor device with a conventional configuration as described above, a degradation phenomenon occurs in which the forward-direction voltage increases. Below, this phenomenon is called the "forward-direction voltage degradation phenomenon". This forward-direction voltage degradation phenomenon is in essence caused by linear crystal defects due to crystal dislocations, called basal plane dislocations, which propagate from the substrate 103 through the drift layer 105. Such defects can become the starting-points for defects, called stacking faults, occurring in the form of numerous planes. Electron-hole recombination occurs readily in such stacking faults, and consequently the resistance in the drift layer 105 rises, and the forward-direction voltage is increased. Stacking faults grow so as to broaden within the drift layer 105, excited by the energy released in electron-hole recombination and by the heat generated by the forward-direction current. Because the cathode region 109 and JTE layer 107 are formed by ion implantation, numerous crystal defects exist in the junction with the drift layer 105.

The inventors have focused on the following. The forward-direction current flows through the cathode region 109, but a portion also flows through the drift layer 105 via the JTE layer 107. At this time, as described above, stacking faults, which are crystal defects starting from basal plane dislocations in the substrate 103 and drift layer 105, are created and expand. With these crystal defects as sources, stacking faults expand in the drift layer 105 below the cathode region 109 and JTE layer 107, and degradation advances. Stacking faults which have expanded within the drift layer 105 below the JTE layer 107 also penetrate into the drift layer 105 between the cathode region 109 and the substrate 103, so that stacking faults expand throughout the entirety of the drift layer 105, and the density of stacking faults is increased. When the density of stacking faults increases and the forward-direction voltage rises, the amount of heat generated within the diode increases, so that the growth of stacking faults is accelerated.

For example, in the case of a SiC PIN diode with a withstand voltage of 5 kV, the forward-direction voltage is 3.5 V for a new device at a forward-direction current density of 100 A/cm². However, after passing current for one hour at a current density of 100 A/cm², the forward-direction voltage increases to 20 V. As the current passage time increases further, the increase in forward-direction voltage shows a tendency toward saturation, but increases gradually nonetheless. Due to the increase in forward-direction voltage, power losses occurring within the PIN diode increase markedly, and the resulting heat generation may cause failure of the device. Thus compared with a Si semiconductor device, a SiC or other wide-gap bipolar semiconductor device, despite having excellent initial characteristics, undergoes rapid degradation and has extremely poor reliability. Hence it has been difficult to use wide-gap bipolar semiconductor devices to realize high-reliability inverters and other power conversion equipment which have low power losses and can be operated over long periods of time.

A high-withstand voltage semiconductor device of the prior art such as that shown in the prior art example of Fig 7, in which a JTE layer 107 for field relaxation is provided in contact with the edge portions 112 of the main junction 110, is advantageous with respect to achieving a high withstand voltage. However, as explained above, defects occurring below the JTE layer 107 cause the occurrence of the forward-direction voltage degradation phenomenon, which is undesirable. When a forward-direction voltage is applied to the PIN diode shown in Fig. 7, the forward-direction current flows to pass not only through the main junction 110, but also through the cathode region 109, JTE layer 107 for field relaxation, and the drift layer 105 therebeneath. Consequently stacking faults occur even in the drift layer 105 below the JTE layer 107, and these grow and expand. As a result, forward-direction voltage degradation is further accelerated. The JTE layer 107 is formed on the periphery of the main junction 110, and so occupies a comparatively large area. Compared with the area of the main junction 110, the area of the JTE layer 107 is considerably large, and the effect on forward-direction voltage degradation is large. Further, the higher the withstand voltage of the PIN diode, the thicker is the drift layer 105, so that defects in the lower portion of the JTE layer 107 act as starting-points for the occurrence of stacking faults which intrude into the drift layer 105 below the main junction 110 as well. As a result, forward-direction voltage degradation may be further accelerated.

The substrate of a SiC or other wide-gap bipolar semiconductor device is normally formed such that the surface is at a prescribed angle to a crystal plane. This angle is called the "off angle" by practitioners of the art, and is normally 15° or less. By providing an off angle, when a drift layer and similar are formed by epitaxial growth on the substrate surface, local growth on the surface of regions with crystal planes different from that of the substrate can be prevented, and crystal defects occurring in the growth layer can be reduced. However, when a substrate having an off angle is used, the above-described linear defects called basal plane defects are formed in and propagate within the drift layer and other epitaxially grown layers at the same angle to the substrate surface as the off angle. Moreover, these become base points for planar defects called stacking faults. Hence stacking faults exist in two-dimensional planes which obliquely cross the current flowing between the device surface and the substrate, and so the forward-direction voltage degradation is increased.

On the other hand, when the off angle reaches 90°, the linear defects called basal plane dislocations are formed in and propagate in the direction perpendicular to the substrate surface within the epitaxially grown layers. Moreover, the planar defects called stacking faults which are generated with these defects as starting-points exist parallel to the current flowing between the device surface and the substrate. As a result, compared with stacking faults having an off angle which results in oblique crossing of the current, the extent of crossing of the current is slight. Moreover, electrons and holes undergo Brownian motion within the crystal while flowing, so that even in stacking faults which are perpendicular to the substrate, electron-hole recombination occurs, and forward-direction voltage degradation occurs.

This invention has as an object the provision of a long-lifetime, highly reliable semiconductor device, in which the above problems are resolved, and the forward-direction voltage degradation of the high-withstand voltage wide-gap semiconductor device is reduced.

### MEANS TO SOLVE THE PROBLEMS

A wide-gap semiconductor device of this invention has p-type and n-type semiconductor regions which operate as a bipolar semiconductor device. The wide-gap semiconductor device has a first pn junction formed by p-type and n-type semiconductor regions which operate as a bipolar semiconductor device, and forming a current path in the semiconductor regions, and an electric field relaxation layer provided within one of the semiconductor regions so as to be separated to an edge of the first pn junction, having a conduction type different from that of the one of the semiconductor regions, and forming a second pn junction with the one of the semiconductor regions surrounding thereof. A first electrode, which is in the current path of the bipolar semiconductor device, is electrically connected to the other semiconductor region forming the first pn junction, and is opposed, across an electrically insulating film, to the semiconductor region between the first pn junction and the second pn junction. A second electrode is provided in the one semiconductor region.

According to this invention, a field relaxation layer is formed at a distance from the first pn junction, so that the forward-direction current flows only through the first pn junction, and there is almost no current flowing through the field relaxation layer and second pn junction. Hence stacking faults due to forward-direction current are formed in the region in which forward-direction current flows in the semiconductor region opposing the first pn junction, and almost no stacking faults occur within the semiconductor region opposing the field relaxation layer. As a result, growth and expansion of stacking faults are suppressed within the semiconductor region opposing the first pn junction, and there is little degradation of the semiconductor device.

Moreover, a configuration is employed in which the first electrode, electrically connected to the semiconductor region forming the first pn junction, opposes the semiconductor region between the first pn junction and the field relaxation layer, with an insulating film intervening. By means of this configuration, when a reverse voltage is applied to the first electrode, charge of polarity opposite the applied voltage, that is, electrons or holes, accumulate in the semiconductor region between the first pn junction edges and the field relaxation layer due to the electric field effect. As a result, the first pn junction and the second pn junction enter an electrically connected state, and a high withstand voltage can be achieved. By this means, a long-lifetime wide-gap semiconductor device having high withstand voltage characteristics can be realized.

The wide-gap semiconductor device of another aspect of the invention has p and n conduction type semiconductor regions which operate as a bipolar semiconductor device. The wide-gap semiconductor device has a first pn junction, forming a current path in the semiconductor region, and an electric field relaxation layer, provided within one semiconductor region among the semiconductor regions at a distance from the edge of the first pn junction, having a conduction type different from the conduction type of the semiconductor region on the periphery of the one semiconductor region, and which forms a second pn junction between the peripheral semiconductor regions. A first electrode, which is in the current path of the bipolar semiconductor device, is electrically connected to the other semiconductor region forming the first pn junction, and is opposed, across an electrically insulating film, to the semiconductor region between the first pn junction and the second pn junction. A second electrode is provided in the one semiconductor region. When a voltage is applied across the electrode and the semiconductor region comprising the first pn junction such that a depletion layer occurs in the semiconductor region, the first electrode imparts an electric field effect to the semiconductor region between the first pn junction and the second pn junction, with the electrically insulating film intervening. By means of this electric field effect, the first pn junction and second pn junction enter an electrically connected state.

According to this invention, a field relaxation layer is formed at a distance from the first pn junction, so that the forward-direction current flows only through the first pn junction, and there is almost no current flowing through the field relaxation layer and second pn junction. Hence stacking faults due to forward-direction current are formed in the region in which forward-direction current flows in the semiconductor region opposing the first pn junction, and almost no stacking faults occur within the semiconductor region opposing the field relaxation layer. As a result, growth and expansion of stacking faults are suppressed within the semiconductor region opposing the first pn junction, and there is little degradation of the semiconductor device.

Moreover, a configuration is employed in which the first electrode, electrically connected to the semiconductor region forming the first pn junction, opposes the semiconductor region between the first pn junction and the field relaxation layer, with an insulating film intervening. Consequently when a reverse voltage is applied to the first electrode, charge of polarity opposite the applied voltage, that is, electrons or holes, accumulate in the semiconductor region between the first pn junction edges and the field relaxation layer due to the electric field effect. As a result, the first pn junction and the second pn junction enter an electrically connected state, and a high withstand voltage can be achieved. The depletion layer expands in the semiconductor region comprising the first pn junction and second pn junction, so that the electric field concentration at the edge portions of the first pn junction is avoided, and a field relaxation effect is obtained equivalent to that of the configuration in which the field relaxation layer is in contact with the edge portions of the first pn junction. By this means, a long-lifetime wide-gap semiconductor device having high withstand voltage characteristics can be realized.

The wide-gap semiconductor device of another aspect of the invention has a semiconductor layer of a first conduction type, and a mesa-type semiconductor layer of a second conduction type, forming a first pn junction with the semiconductor layer of the first conduction type. A field relaxation layer of the second conduction type is formed within the semiconductor layer of the first conduction type, at a distance from the first pn junction. A first electrode, connected to the mesa-type semiconductor layer, opposes the semiconductor layer between the first pn junction and the field relaxation layer, with an electrical insulation film intervening. A second electrode is provided in a semiconductor layer of the first conduction type.

According to this invention, by means of the electrical field effect imparted by the first electrode, through the electrical insulation film, to the semiconductor layer between the first pn junction and the field relaxation layer in the mesa-type semiconductor device, when the semiconductor device is reverse-biased the first pn junction and the field relaxation layer are electrically connected, and when forward-biased the two are electrically isolated. By this means, forward-direction current does not flow through the field relaxation layer, and forward-direction voltage characteristic degradation is reduced without detriment to the high withstand voltage characteristic, so that both a high withstand voltage and high reliability can be attained.

The wide-gap semiconductor device of another aspect of the invention has a semiconductor layer of a first conduction type, and a planar-type semiconductor layer of a second conduction type, forming a first pn junction with the semiconductor layer of the first conduction type. A field relaxation layer of the second conduction type is formed within the semiconductor layer of the first conduction type, at a distance from the first pn junction. A first electrode, connected to the planar-type semiconductor layer, opposes the semiconductor layer between the first pn junction and the field relaxation layer, with an electrical insulation film intervening. A second electrode is connected to a semiconductor layer of the first conduction type.

According to this invention, by means of the electrical field effect imparted by the first electrode, through the electrical insulation film, to the semiconductor layer between the first pn junction and the field relaxation layer in the planar-type semiconductor device, when the semiconductor device is reverse-biased the first pn junction and the field relaxation layer are electrically connected, and when forward-biased the two are electrically isolated. By this means, forward-direction current does not flow through the field relaxation layer, and forward-direction voltage characteristic degradation is reduced without detriment to the high withstand voltage characteristic, so that both a high withstand voltage and high reliability can be attained.

A wide-gap semiconductor device of another aspect of this invention has p and n conduction type semiconductor regions which operate as a bipolar semiconductor device. The wide-gap semiconductor device has a first pn junction, forming a current path in the semiconductor region, and an electric field relaxation layer, provided at a distance from the edge of the first pn junction, within a second semiconductor region which forms the first pn junction, having a conduction type different from the conduction type of the second semiconductor region, and forming a second pn junction with the peripheral semiconductor region. The wide-gap semiconductor device further has a third semiconductor region, formed on the first semiconductor region which forms the first pn junction, of conduction type different from at least one of the above first semiconductor regions. A first electrode is electrically connected to the third semiconductor region, and the edge portion opposes the second semiconductor region between the first pn junction and the second pn junction, with an electrically insulating film intervening. A second electrode is electrically connected to the first semiconductor region forming the first pn junction. The wide-gap semiconductor device further has a fourth semiconductor region, differing from the second semiconductor region, provided opposing the face of the second semiconductor region having the first pn junction, and a third electrode, provided in the fourth semiconductor region.

According to this invention, when a high forward-bias voltage is applied to the wide-gap semiconductor device, due to the electric field effect imparted by the first electrode through the electrically insulating film to the second semiconductor region between the first pn junction and the second pn junction, the first pn junction and second pn junction are electrically connected, and when a low forward-bias voltage is applied, the two are electrically isolated. Because of this, current does not flow through the field relaxation layer. As a result, forward-direction voltage degradation, and degradation of the on gate current characteristic and controllable current characteristic, can be reduced while maintaining a high withstand voltage, and both a high withstand voltage and high reliability can be realized.

A wide-gap semiconductor device of another aspect of this invention has p and n conduction type semiconductor regions which operate as a bipolar semiconductor device. The wide-gap semiconductor device has at least two first pn junctions, forming a current path in the semiconductor region, and an electric field relaxation layer, provided at a distance from the edge of the first pn junctions, within a first semiconductor region which forms the first pn junction, having a conduction type different from the conduction type of the first semiconductor region, and forming a second pn junction. The wide-gap semiconductor device further has a third semiconductor region, formed in one of second semiconductor regions which forms the first pn junction, and has a conduction type different from at least one of the second semiconductor regions. A first electrode is electrically connected to the third semiconductor region, and the edge portion is opposed, with an electrically insulating film intervening, to the semiconductor region between the first pn junction and the second pn junction. A second electrode is electrically connected to another fourth semiconductor region which forms the first pn junction. A third electrode is opposed, with an insulating film intervening, to the semiconductor region between at least two of the first pn junctions. A fourth electrode is provided in the fourth semiconductor region.

According to this invention, when the forward-bias voltage on the wide-gap semiconductor device is high, due to the electric field effect imparted by the first electrode through the electrically insulating film to the semiconductor region between the first pn junctions and the second pn junction, the first pn junctions and second pn junction are electrically connected, and when the forward-bias voltage is low they are electrically isolated, and current does not flow through the field relaxation layer. By this means, forward-direction voltage degradation is reduced while maintaining a high withstand voltage, and a semiconductor device can be realized having a high withstand voltage and high reliability while suppressing increases in power losses.

A power device of this invention comprises a wide-gap semiconductor device as a control device. The wide-gap semiconductor device has p and n conduction type semiconductor regions which operate as a bipolar semiconductor device, and has at least two pn junctions, forming a current path in the semiconductor region, and an electric field relaxation layer, provided at a distance from the edge portions of the first pn junctions and within a first semiconductor region which forms the first pn junctions, having conduction type different from the first semiconductor region, and forming a second pn junction. The wide-gap semiconductor device further has a third semiconductor region, formed in one of second semiconductor regions forming the first pn junctions, and having conduction type different from at least one of the second semiconductor regions, as well as a third semiconductor region, having conduction type different from at least one of the second semiconductor regions, and a first electrode, electrically connected to the third semiconductor region, and the edge portion of which opposes, through an electrically insulating film, the semiconductor region between the first pn junctions and the second pn junction. The wide-gap semiconductor device further has a second electrode, electrically connected to another, fourth semiconductor region forming a first pn junction, a third electrode, which opposes the semiconductor region between at least two first pn junctions with an insulating film intervening, and a fourth electrode, electrically connected to the fourth semiconductor region.

According to this invention, when the forward-bias voltage on the wide-gap semiconductor device is high, due to the electric field effect imparted by the first electrode through the electrically insulating film to the semiconductor region between the first pn junctions and the second pn junction, the first pn junctions and second pn junction are electrically connected, and when the forward-bias voltage is low they are electrically isolated, and current does not flow through the field relaxation layer. By this means, forward-direction voltage degradation is reduced while maintaining a high withstand voltage, and power losses in the wide-gap semiconductor device can be greatly suppressed. Hence in power devices comprising a wide-gap semiconductor device of this invention, power losses can be suppressed, and both a high withstand voltage and high reliability can be realized.

### EFFECT OF THE INVENTION

According to this invention, stacking faults which occur when a forward-direction current is flowing in a wide-gap semiconductor device are formed primarily in the portion of the semiconductor region in which the forward-direction current is flowing, and so growth and expansion of stacking faults can be suppressed, and rises in forward-direction voltage due to increases in stacking faults can be suppressed.

### BRIEF DESCRIPTION OF THE DRAWINGS

Fig. 1 is a cross-sectional view of a mesa-structure SiC PIN diode, which is the wide-gap semiconductor device of a first embodiment of the invention;
Fig. 2 is a cross-sectional view of a planar-structure SiC PIN diode, which is the wide-gap semiconductor device of a second embodiment of the invention;
Fig. 3 is a cross-sectional structure of a mesa-structure SiC GTO, which is the wide-gap semiconductor device of a third embodiment of the invention;
Fig. 4 is a cross-sectional view of a mesa-structure SiC MOSFET, which is the wide-gap semiconductor device of a fourth embodiment of the invention;
Fig. 5 is the circuit diagram of an inverter using the SiC MOSFET of the fourth embodiment;
Fig. 6 is a cross-sectional view showing an example of a configuration in which, in the SiC PIN diode of this invention shown in Fig. 1, a stopper 3 is provided in the opening between both edge portions of the Ohmic contact layer 8 and the insulating film 17; and,
Fig. 7 is a cross-sectional view of a planar-structure SiC PIN diode, which is the wide-gap semiconductor device of an example of the prior art.

### EXPLANATION OF THE REFERENCED NUMERALS

- 3: stopper
- 8, 10, 28a: Ohmic contact layer
- 13, 23: anode layer
- 12, 22, 42, 105: drift layer
- 12a, 22a: valley portions
- 42a, 42b: drift layer portion
- 17, 29, 39, 91, 92, 93, 50a, 50b: Gate insulating film
- 14, 24, 30a: contact layer
- 40, 81, 82, 83: gate electrode
- 71, 72, 73, 74: source electrode
- 61, 62, 63, 64, 65, 66: Source layer
- 51, 52, 53, 54: body layer
- 11, 21, 32, 41, 103: substrate
- 19, 30, 31, 113: cathode electrode
- 18, 28, 37, 101: anode electrode
- 33: buffer region
- 34, 34a: base region
- 35: base layer
- 36: emitter layer
- 16, 27, 49a, 49b: channel stopper layer
- 15, 17, 25, 38, 48a, 48b, 107: JTE layer
- 110: main junction
- 26: RESURF layer
- 109: cathode region

### BEST MODE FOR CARRYING OUT THE INVENTION

Below, preferred embodiments of high-withstand voltage wide-gap semiconductor devices and power devices of this invention are explained, referring to Fig. 1 through Fig. 6. Although not shown in the figures, the high-withstand voltage wide-gap semiconductor devices of the embodiments may be circular, square-shaped, rectangular, or other shapes in plane view.

### «First Embodiment»

Fig. 1 is a cross-sectional view of a mesa-structure SiC PIN junction diode, which is the high-withstand voltage wide-gap semiconductor device of a first embodiment of the invention. In the figure, an n⁻-type SiC semiconductor drift layer 12 of thickness 75 µm and with impurity concentration 1x10¹⁴ cm⁻³ is formed, by epitaxial growth techniques, on a substrate 11 of n⁺-type SiC semiconductor, with impurity concentration 1x10¹⁹ cm⁻³, which acts as a cathode of thickness 400 µm. On the lower surface of the substrate 11 is provided a cathode electrode 19 (second electrode) of gold, copper or similar, with an Ohmic contact layer 10 intervening to maintain a satisfactory state of electrical contact. On the drift layer 12 are formed, in order, a p⁺-type SiC semiconductor anode layer 13, with impurity concentration 1x10¹⁸ cm⁻³ and thickness 1.5 µm, and a p⁺-type SiC semiconductor contact layer 14, with impurity concentration 1x10¹⁹ cm⁻³ and thickness 0.2 µm, using epitaxial growth techniques. Between the drift layer 12 and anode layer 13 is formed a junction 2 (first pn junction).

Next, etching is performed, leaving the center portion of the device surface, to obtain a mesa structure. The mesa height is approximately 2 µm. Ion implantation techniques are used to form, in the drift layer 12 exposed by etching, a JTE (Junction Termination Extension) layer 15, which is an electric field relaxation layer, of p-type SiC semiconductor with lateral-direction length of approximately 150 µm, thickness of 0.7 µm and impurity concentration 3.5x10¹⁷ cm⁻³, at a distance of approximately 3 µm from both edge portions of the anode layer 13. No problems were encountered even when the above distance of 3 µm by which the JTE layer 15 was removed from both edge portions of the anode layer 13 was reduced to approximately 0.5 µm. By this means, valley portions 12a are formed. A junction 4 (second pn junction) is formed between the JTE layer 15 and the drift layer 12. Further, ion implantation techniques are used to form a channel stopper layer 16, of n⁺-type SiC semiconductor, with impurity concentration 8x10¹⁸ cm⁻³, at a distance of approximately 30 µm from the JTE layer 15.

The low portion surrounding the mesa, the mesa side faces, and both edge portions of the mesa top face are covered with a silicon dioxide insulating film 17 of thickness approximately 0.5 µm, to protect the surface. The fixed charge density at the covering interface is approximately 1x10¹² cm⁻². An anode 18 (first electrode) of gold, copper or similar is provided on the contact layer 14, with an Ohmic contact layer 8 intervening. The Ohmic contact layer 8 is generally formed from a metal material comprising titanium and nickel. The SiC PIN diode of this embodiment may be heated to elevated temperatures of 400 to 700°C in the process of formation of the Ohmic contact layer 8. During heating to these elevated temperatures, the Ohmic contact layer 8 is softened, assuming liquid form, and may intrude into the interface between the insulating film 17 and contact layer 14, and into the interface between the mesa oblique faces of the anode layer 13 and the insulating film 17, and cause obstructions.

In this embodiment, an opening is provided between both edge portions of the Ohmic contact layer 8 and the insulating layer 17, and the protruding portion 18a of the anode 18 is inserted into the opening, configured such that the Ohmic contact layer 8 is not in contact with the insulating film 17. The protruding portion 18a is in direct contact with the contact layer 14. Instead of providing a protruding portion 18a on the anode 18, an insertion member called a stopper 3 may be provided in the opening, as shown in Fig. 6. The material for the stopper 3 can be a material which does not react readily with the metal material of the Ohmic contact layer 8; for example, aluminum nitride, a polyimide resin, or another heat-resistant insulator, or aluminum or another metal different from the anode 18, can be used.

The anode 18 is formed on the insulating film 17 as well, and the outer periphery or edge portions thereof extend onto the JTE layer 15 to a position of approximately 10 µm from the inside edges of the JTE layer 15. That is, the two edge portions of the anode 18 overlap the JTE layer 15 in opposition, with the insulating film 17 intervening. The junction 2, which is the first pn junction, is formed between the drift layer 12 and the anode layer 13. This SiC PIN junction diode is packaged in a can-type package and covered with insulating resin, with an inert gas sealed inside, to form the semiconductor device.

Upon applying a reverse voltage (hereafter called a reverse bias) across the anode 18 and cathode 19 of the SiC PIN junction diode of this embodiment, configured as described above, and measuring the withstand voltage, a value of approximately 6750 V was obtained. This withstand voltage is substantially the same as the withstand voltage of a diode of the same size with a conventional structure, configured such that the JTE layer 15 is in contact with the anode layer 13. The inventors have confirmed that this is due to the following reason.

When the SiC PIN junction diode of this embodiment is reverse-biased, the anode 18 is at lower potential than the drift layer 12. Consequently, due to the field effect imparted from both edge portions of the anode 18 through the insulating film 17, numerous holes, indicated by "+" symbols, are induced in the portions called the valley portions 12a of the drift layer 12 between the anode 13 and the JTE layer 15 (between the first pn junction and second pn junction). The hole density is high in the vicinity of the surface near the insulating film 17. As a result, in the surface vicinity of the valley portions 12a near the insulating film 17, the n-type SiC semiconductor is inverted to become p-type SiC semiconductor, effectively equivalent to a conventional configuration in which the JTE layer 15 is provided in contact with the anode layer 13. A portion from the valley portions 12a extending far from the insulating film 17 is depleted. The voltage applied to the anode 18 which is sufficient to cause inversion to a p-type SiC semiconductor layer of the n-type SiC semiconductor layer in the surface vicinity of the valley portions 12a must be a voltage lower than the breakdown voltage at which avalanche breakdown of the junction 2 occurs. In order to lower the applied voltage below the breakdown voltage, the material and thickness of the insulating film 17 must be changed, or the amount of ions in the insulating film 17 changed to adjust the charge and adjust the amount of fixed charge at the interface between the insulating film 17 and SiC semiconductor layer. In order to confirm the field effect due to the anode 18, the inventors trial-fabricated a PIN diode in which the anode 18 extended only to the positions of the dashed lines 6 in Fig. 1, and is not opposed to the valley portions 12a or the edge portions of the JTE layer 15, and performed tests. As a result, the withstand voltage was found to be 4600 V, or approximately 2150 V lower than the previous value of 6750 V.

Upon applying a voltage in the forward direction (hereafter called a forward bias) to a new SiC PIN junction diode of this embodiment and passing current for one hour at a current density of 100 A/cm², the forward-direction voltage, which immediately after the start of current flow had been 4.1 V, rose to approximately 4.9 V after one hour of current flow. When the current passage time was further extended, the increase in forward-direction voltage showed a tendency toward saturation, and thereafter increased gradually by a small amount. During forward-biasing, the anode 18 is at a higher potential than the drift layer 12, so that due to the field effect induced by the anode 18, electrons rather than holes are induced in the valley portions 12a of the drift layer 12. Therefore, the anode layer 13 and the JTE layer 15 are electrically completely separated. As a result, the forward-direction current flows only in the junction 2 of the anode layer 13, and does not flow passing through the junction 4 (second pn junction) of the JTE layer 15 and drift layer 12.

If the portions of the two end portions of the anode 18 overlapping and opposing the JTE layer 15 are made too long, the potential difference between the end portions of the anode 18 and the JTE layer 15 becomes large, and there is the danger of dielectric breakdown of the insulating film 17. Hence it is desirable that the length of the anode 18 be set such that dielectric breakdown of the insulating film 17 in contact with the anode 18 does not occur even when a voltage close to the voltage causing avalanche breakdown of the junction 2 is applied to the anode 18. Or, as another method, the insulating film 17 may be made thicker in the portions in the vicinity of the end portions of the anode 18 than in other portions.

When a forward-direction current flows in the SiC PIN junction diode of this embodiment, stacking faults occur within the drift layer 12 between the junction 2 and the substrate 11, and forward-direction voltage degradation advances. As explained above, this forward-direction voltage degradation causes the forward-direction voltage to rise from 4.1 V to 4.9 V. However, in the case of a PIN junction diode with a conventional structure, in which the JTE layer 15 is formed in contact with the anode layer 13, upon passing a current for one hour at a current density of 100 A/cm², the forward-direction voltage rises from 4.1 V to approximately 8.4 V, indicating that the forward-direction voltage degradation is more pronounced than for the PIN junction diode of this embodiment.

As explained above, according to this embodiment, due to the field effect of the anode 18 acting through the surface protection insulating film 17 of the SiC PIN diode when a reverse bias is applied, the function 2 and JTE layer 15 are electrically connected. Moreover, during forward biasing the function 2 and JTE layer 15 are electrically separated, and a forward-direction current does not flow through the junction 4 between the JTE layer 15 and drift layer 12. As a result, forward-direction voltage degradation can be reduced while maintaining a high withstand voltage, and a SiC PIN junction diode with long lifetime and high reliability is obtained.

### «Second Embodiment»

Fig. 2 is a cross-sectional view of a planar-structure SiC PIN junction diode, which is the semiconductor device of a second embodiment of the invention. In the figure, an n-type SiC drift layer 22, with impurity concentration 5x10¹⁴ cm⁻³ and of thickness 50 µm, is formed by epitaxial growth techniques on an n⁺-type SiC substrate 21, with impurity concentration 1x10¹⁹ cm⁻³ and of thickness 400 µm, operating as a cathode. In the center region of the drift layer 22, ion implantation techniques are used to form a p⁺-type SiC anode layer 23, with impurity concentration 1x10¹⁸ cm⁻³ and of thickness 0.5 µm, and a p⁺-type SiC contact layer 24, with impurity concentration 1x10¹⁹ cm⁻³ and of thickness 0.2 µm. A function 20 (first pn junction) is formed between the anode layer 23 and the drift layer 22.

Further, p -type SiC JTE layers 25, with impurity concentration 8x10¹⁷ cm⁻³, of thickness 0.8 µm and length in the lateral direction approximately 25 µm, are provided at a distance of approximately 5 µm from both edge portions of the anode layer 23. The distance of approximately 5 µm by which the JTE layers 25 are removed from both edge portions of the anode layer 23 was also increased to approximately 22 µm without any particular problems. By this means, valley portions 22a are formed. Also, p⁻-type SiC RESURF (reduced surface field) layers 26, with impurity concentration 2.0x10¹⁶ cm⁻³, of thickness 0.7 µm and lateral-direction length approximately 75 µm, were formed by ion implantation techniques so as to be connected to each of the JTE layers 25, and to operate as electric field relaxation layers. Junctions 20a (second pn junctions) are formed between the JTE layers 25 and RESURF layers 26, and the drift layer 22. Also, n⁺-type SiC channel stopper layers 27 are formed by ion implantation techniques at both edge portions, removed a distance from the RESURF layers 26. An anode 28 (first electrode) is connected, via an Ohmic contact layer 28a, to the contact layer 24.

Similarly to the first embodiment shown in Fig. 1, an opening is provided between both edge portions of the Ohmic contact layer 28a and the insulating film 29. The protruding portion 28b, protruding from the lower face of the anode 28, enters into this opening, and isolates the Ohmic contact layer 28a from the insulating film 29. In place of the protruding portion 28b of the anode 28, a stopper (not shown) may be provided in the opening. Except for the portion connected to the anode 28, the surface of the device is covered with an insulating film 29 which is an oxide film of thickness approximately 0.3 µm. The anode 28 is also formed on the insulating film 29, and both edges thereof are made to overlap by approximately 5 µm and oppose the JTE layers 25, with the insulating film 29 intervening. A cathode 30 is provided on the lower surface of the substrate 21, with an Ohmic contact layer 30a (second electrode) intervening.

This SiC PIN junction diode is packaged in a can-type package, covered with an insulating resin, with an inert gas sealed inside, to form the semiconductor device.

Upon applying a reverse voltage across the anode 28 and cathode 30 and measuring the withstand voltage, a value of approximately 4100 V was obtained. This withstand voltage is substantially the same as the withstand voltage of a SiC PIN junction diode of the same size with a conventional structure, in which the anode layer 23 and JTE layers 25 are in contact. This is for the following reason. Similarly to the above-described first embodiment, when the SiC PIN junction diode of this embodiment is reverse-biased, due to the field effect imparted by the anode 28 on the surface vicinity of the valley portions 22a between the anode layer 23 and JTE layers 25 through the insulating film 29, holes, indicated by "+" symbols, are induced in the vicinity of the surface of the drift layer 22 of the valley portions 22a. As a result the surface vicinity of the n-type SiC drift layer 22 is partially inverted to p-type SiC, effectively equivalent to a case in which the JTE layers 25 are formed so as to be in contact with the anode layer 23. Depletion occurs in a portion removed a distance from the surface of the valley portions 22a. For comparison, upon trial-fabricating and testing a SiC PIN diode configured with the two edge portions of the anode 28 not extended to above the JTE layers 25, the withstand voltage was 2600 V, lower by approximately 1500 V than the above value of approximately 4100 V.

Upon passing a current in the forward direction through a new SiC PIN junction diode of this embodiment at a current density of 100 A/cm², the forward-direction voltage, which had been 4.6 V immediately after the start of the current, rose to approximately 5.2 V after one hour; the increase was a comparatively small 0.6 V. Upon further extending the current passage time, a tendency toward saturation of the increase in forward-direction voltage was seen, and thereafter there was a slight gradual increase.

In a SiC PIN junction diode of this embodiment, during forward-biasing the potential at the anode 28 is higher than in the drift layer 22, so that due to the field effect imparted by the anode 28 to the drift layer 22 through the insulating film 29, electrons (not shown) are drawn toward and gather in the valley portions 22a. As a result, the anode 23 and JTE layers 25 are electrically completely separated. The forward-direction current passes through the anode layer 23, and flows through the region of the drift layer 22 in contact with the anode layer 23, but current does not flow in the JTE layers 25 or RESURF layers 26 which are electrically separated from the anode layer 23. Consequently stacking faults occur primarily within the drift layer 22 between the anode layer 23 and the substrate 21, whereas stacking faults occur hardly at all in the drift layer 22 between the JTE layers 25 and RESURF layers 26, and the substrate 21. As a result, the forward-direction voltage after current has been passed for one hour increases by only the comparatively small amount of approximately 0.6 V.

For purposes of comparison with a SiC PIN junction diode of this embodiment, forward-direction current at a current density of 100 A/cm² was passed through a SiC PIN junction diode with a conventional structure, in which the JTE layers 25 were formed in contact with the anode layer 23, and the forward-direction voltage was found to increase markedly from 4.6 V to approximately 10.6 V. This is because the JTE layers 25 are formed by ion implantation, so that there exist numerous defects in the junction portion with the drift layer 22, and stacking faults grow from these defects during passage of a current, expanding into the drift layer 22 between the junctions 20a and the substrate 21, and in addition intruding into the drift layer 22 between the anode layer 23 and the substrate 21, to increase the defect density and hasten degradation of the forward-direction voltage. When the forward-direction voltage increases due to acceleration of forward-direction voltage degradation, heating increases within the PIN junction diode, and the growth of stacking faults is further accelerated.

According to this embodiment, due to the field effect imparted from the edge portions of the anode 28 of the planar-structure SiC PIN diode, through the insulating film 29, to the valley portions 22a of the drift layer 22 between the anode layer 23 and the JTE layers 25, during reverse-biasing the junction 20 and JTE layers 25 are electrically connected. Further, during forward-biasing the anode layer 23 and JTE layers 25 are electrically cut off from the valley portions 22a, and forward-direction current does not flow through the JTE layers 25. As a result, increases in the forward-direction voltage due to forward-direction voltage degradation can be suppressed while maintaining a high withstand voltage, and a highly reliable high-withstand voltage PIN junction diode is obtained.

### «Third Embodiment»

Fig. 3 is a cross-sectional view of a mesa-structure SiC GTO which is the high-withstand voltage, wide-gap semiconductor device of a third embodiment of the invention. In the figure, a p-type SiC buffer region 33 is formed on the upper surface of the substrate 32, comprising an n⁺-type SiC emitter region, and having a cathode 31 (second electrode) on the lower surface. On the buffer region 33 is formed a p⁻-type SiC base region 34; in the center of the base region 34 is formed a mesa-structure n-type SiC base layer 35. A junction 30 (first pn junction) is formed between the base region 34 and the base layer 35. Four gate electrodes 40 are provided in the base layer 35. The four gate electrodes 40 are connected at a portion not shown in the figure. A p-type SiC emitter layer 36 is formed between each of the gate electrodes 40.

The n⁺-type SiC substrate 32 has an impurity concentration of 1x10¹⁹ cm⁻³, and a thickness of 300 µm. The buffer region 33 has an impurity concentration of 3x10¹⁷ cm⁻³ and thickness 2.5 µm. The base region 34 has an impurity concentration of 5x10¹³ cm⁻³ and thickness 150 µm. The base layer 35 has an impurity concentration of 1x10¹⁸ cm⁻³ and thickness 1.8 µm. The emitter layers 36 have an impurity concentration of 1x10¹⁹ cm⁻³ and thickness 1.5 µm. The base layer 35 and emitter layers 36 are both formed using epitaxial growth techniques. The edge portions of the base layer 35 are shaped into a mesa shape; the mesa height is approximately 3.7 µm. Ion implantation techniques are used to form JTE layers 38, which are n-type SiC electric field relaxation layers, in the low portion surrounding the mesa, separated by approximately 4.0 µm from the edge portions of the base layer 35, with an impurity concentration of 3.5x10¹⁷ cm⁻³, thickness 0.7 µm, and length approximately 250 µm. A junction 30a (second pn junction) is formed between the JTE layers 38 and base region 34. The surface of the lower portion surrounding the mesa, the oblique face of the mesa, and the upper-face emitter layers 36 of the mesa excluding the upper-face center portion, are covered by an insulating film 39 which is an oxide film for surface protection, of thickness approximately 0.6 µm. An anode 37 (first electrode), electrically connected to each of the emitter layers 36, is provided on the insulating film 39. The edge portions of the anode 37 are extended to a region approximately 15 µm distant so as to be opposed, with the insulating film 39 intervening, to the mesa oblique face and the edge portions of the JTE layers 38 on the side of the mesa oblique face. Also, p⁺-type SiC channel stopper layers 27 are formed at both the edge portions, removed a distance from each of the JTE layers 38.

The SiC GTO with the above structure is packaged in a can-type package, covered with an insulating resin with a thickness of about 1 mm, with an inert gas sealed inside, to form the semiconductor device.

Upon connecting the gate electrode 40 to the anode 37 of the SiC GTO of this embodiment, applying a forward-direction voltage across the anode 37 and cathode 31, and measuring the withstand voltage, a value of approximately 13,100 V was obtained. This withstand voltage was substantially equal to the withstand voltage of a SiC GTO with a conventional structure, in which the JTE layers 38 are in contact with the edge portions of the base layer 35.

In the GTO of this embodiment, when a forward-direction voltage is applied across the anode 37 and cathode 31 and the forward-bias voltage exceeds a prescribed threshold, due to the field effect imparted from both edge portions of the anode 37 through the insulating film 39, electrons, indicated by "-" symbols, are induced in the p⁻-type SiC base region 34a between the base layer 35 edge portions and the JTE layers 38. Consequently the surface vicinity near the insulating film 39 is inverted to n-type SiC, and the n-type SiC base layer 35 and n⁻-type SiC JTE layers 38 enter a state equivalent to that of being coupled by an inverted n-type SiC region. A portion far from the insulating film 39 is depleted. As a result, the electric field concentration at the edge portions of the base layer 35 is relaxed, and a high withstand voltage is obtained.

For purposes of comparison with a GTO of this embodiment, a GTO with the same positional relationship between the base layer 35 and JTE layers 38 as in this embodiment, but with the edge portions of the anode 37 extending only to the positions indicated by the dashed lines 37a in Fig. 3, was trial-fabricated, and upon measuring the forward-direction withstand voltage, a value of 7400 V was obtained. This withstand voltage was lower by 5700 V than the withstand voltage of 13, 100 V of the GTO of this embodiment. Based on this comparison, it was confirmed that by causing the anode 37 to extend to positions opposing JTE layers 38 in the GTO of this embodiment, the withstand voltage can be greatly increased.

When a forward-direction voltage is applied across the anode 37 and cathode 31 of a SiC GTO of this embodiment, and a gate current is passed from the anode 37 to the gate electrode 40 at a current density of approximately 5 A/cm², the SiC GTO is turned on, and forward-direction current flows. Upon passing forward-direction current at a current density of 100 A/cm² for 100 hours, the forward-direction voltage, which had been 4.6 V at the beginning of the passage of current, increased to approximately 5.3 V after passing current for 100 hours. When the current passage time was further extended, the increase in forward-direction voltage tends toward saturation, and thereafter gradually increases only slightly. This minimal rise in forward-direction voltage occurs because in a SiC GTO of this embodiment, the forward-direction voltage in the turn-on state is several volts or so, as described above, and is lower than the threshold voltage; hence the anode 37 imparts a field effect through the insulating film 39, so that the base region 34a between the base layer 35 and JTE layers 38 is inverted to n type. As a result the base layer 35 and JTE layers 38 are not electrically connected, and current flows only in the base layer 35, and forward-direction voltage degradation advances mainly in the base region 34 between the base layer 35 and the substrate 32.

Fig. 3 is used to explain an SiC GTO in which an opening is not provided between the base layer 35 and JTE layers 38 as in Fig. 3, and these are in contact (a conventional SiC GTO). The forward-direction current flows through substantially the entire region of the base region 34 between the base layer 35 and JTE layers 38, and the substrate 32. The JTE layers 38 are formed by ion implantation, and so numerous defects exist in the junction portions 30a with the base region 34. When current flows through such junction portions 30a having numerous defects, stacking faults arise from the defects, and these expand and penetrate into the portion of the base region 34 enclosed between the base layer 35 and substrate 32. As a result the forward-direction voltage degradation phenomenon occurs over a broad range of the base region 34, and the forward-direction voltage rises.

This conventional GTO was trial-fabricated, and tests performed in which a forward-direction current with current density 100 A/cm² was passed for 20 hours. As a result, the forward-direction voltage, which had been 4.6 V immediately after [the beginning of] current passage, increased to 11.4 V after 20 hours. This occurred because of mutual interpenetration of stacking faults occurring in the lower portions of the JTE layers 38 having numerous defects at the junctions 30a, and stacking faults occurring in the bottom portion of the base layer 35, so that the defect density rose, resulting in the advance of forward-direction voltage degradation. As the stacking fault density rises the forward-direction voltage degradation intensifies, heating within the SiC GTO increases, and the growth of stacking faults is further accelerated.

Because stacking faults thus grow and expand within the base region 34 of a conventional SiC GTO, recombination of electrons and holes increases as a result. Consequently a phenomenon occurs in which the on gate current necessary to turn on the SiC GTO also increases.

In the initial period of use when there are few stacking faults in a conventional SiC GTO, while turned off the device is in a state in which currents are distributed comparatively uniformly in the various portions of the GTO device. However, the advance of degradation is accompanied by growth and expansion of stacking fault portions, and so the current distribution in the GTO device while turned off becomes uneven. As a result, during turn-off operation the residual current is excessively concentrated in portions in which stacking faults do not exist, and there may be current shutoff failure resulting in breakdown of the GTO device. Even when breakdown does not result, the controllable current for which turn-off is possible is lowered.

In a SiC GTO of this invention, the growth and expansion of stacking faults are suppressed, so that degradation phenomena in which the controllable current declines with increasing time of use can be suppressed. Moreover, degradation phenomena in which the on gate current increases can be suppressed.

As explained above, according to this embodiment, when a high forward-direction voltage is applied to the SiC GTO, due to the field effect induced by the anode, the base layer 35 and JTE layers 38 are electrically connected, but when a low forward-direction voltage is applied they are electrically cut off, and current does not flow through the JTE layers 38. By this means, a GTO can be realized in which aging degradation such as increases in forward-direction voltage and in on gate current, and decreases in the controllable current, can be reduced while maintaining a high withstand voltage, to achieve both high reliability and a high withstand voltage.

### «Fourth Embodiment»

Fig. 4 is a cross-sectional view of a SiC MOSFET which is the high-withstand voltage, wide-gap semiconductor device of a fourth embodiment of the invention. In the figure, an n⁻-type SiC drift layer 42, with impurity concentration 9x10¹⁴ cm⁻³ and of thickness 40 µm, is formed by epitaxial growth techniques on an n⁺-type SiC substrate 41 serving as the cathode, with impurity concentration 1x10¹⁹ cm⁻³ and of thickness 350 µm. The upper surface of the drift layer 42 is machined into a mesa shape, and ion implantation techniques are used to form four body layers 51, 52, 53, 54 of p-type SiC, with impurity concentration 1x10¹⁸ cm⁻³ and of thickness 1.5 µm, in the mesa. Junctions 75a, 75b (first pn junctions) are formed by the body layers 51, 52, 53, 54 and the drift layer 42.

Two n⁺-type SiC source layers 61, 62 are formed by ion implantation techniques in the body layer 51, with impurity concentration 1x10¹⁹ cm⁻³ and of thickness 0.6 µm. Similarly, two source layers 63, 64 are formed in the body layer 52. Source layers 65, 66 are formed in each of the body layers 53, 54. Source electrodes 73, 74, which are first electrodes, are connected to approximately half of the face of the source layers 65, 66. A source electrode 71 is provided so as to span the source layers 61 and 62 and to be in contact with approximately half the faces of each; and a source electrode 72 is provided so as to span the source layers 63 and 64 and to be in contact with approximately half the faces of each. Gate insulating films 91, 92, 93, comprising thin oxide film, are provided on the drift layer 42 excluding the source electrodes 71 to 74 and the connection portions of the body layers 51 to 54.

The source electrodes 71 to 74 are connected to a single source terminal 80. A gate electrode 81 is provided on the gate insulating film 91, with both edge portions opposing the source layers 61 and 66. On the gate insulating film 92 is provided a gate electrode 82, with both edge portions opposing the source layers 62 and 63. On the gate insulating film 93 is provided a gate electrode 83, with both edge portions opposing the source layers 64 and 65. The gate electrodes 81, 82, 83 are connected to a single gate terminal 90. The mesa height is approximately 2 µm. Ion implantation techniques are used to form JTE layers 48a, 48b, which are p⁻-type SiC electric field relaxation layers of length approximately 90 µm in the lateral direction, with impurity concentration 3.5x10¹⁷ cm⁻³ cm and thickness 0.7 µm, each removed a distance of approximately 6 µm from the body layers 53, 54 in the low portion on the periphery of the mesa. The distance of 6 µm by which the JTE layers 48a, 48b are removed from the body layers 53, 54 was also reduced to approximately 0.3 µm with no problems in particular resulting. Junctions 85 (second pn junctions) are formed between the JTE layers 48a, 48b and the drift layer 42. Also, n⁺-type SiC channel stopper layers 49a, 49b, of impurity concentration 8x10¹⁸ cm⁻³, are formed by ion implantation techniques at a distance of approximately 25 µm from the JTE layers 48a, 48b respectively.

The low portion of the periphery of the mesa comprising the upper faces of the JTE layers 48a and 48b, and the mesa side faces 59a and a portion of the mesa upper face, are respectively covered with insulating films 50a and 50b comprising oxide film approximately 0.25 µm thick, of thickness far greater than that of the gate insulating films 91 to 93. The edge portions of the source electrodes 73, 74 are extended in opposition over a range of approximately 15 µm from the edges of the JTE layers 48a, 48b with the insulating films 50a, 50b respectively intervening. A drain electrode 79 is provided on the lower face of the substrate 41.

This SiC MOSFET is packaged in a can-type package, covered with an insulating resin, with an inert gas sealed inside, to form the semiconductor device.

A forward-direction voltage was applied across the source terminal 80 and drain electrode 79 of this semiconductor device, and the withstand voltage measured, to obtain a value of approximately 3650 V. This withstand voltage was substantially the same as the withstand voltage of a conventional-structure SiC MOSFET, in which the body layers 53, 54 are formed in contact with the JTE layers 48a, 48b respectively. When a forward-direction voltage is applied to a SiC MOSFET of this embodiment, the source electrodes 73, 74 are at lower potential than the drive layer 42. Hence as a result of the field effect imparted by the source electrodes 73, 74 through the insulating films 50a, 50b to the drift layer portion 42a between the body layer 53 and JTE layer 48a and to the drift layer portion 42b between the body layer 54 and the JTE layer 48b, numerous holes, denoted by the symbols '"+", are induced in the drift layer portions 42a, 42b. Due to these holes, the surface vicinity near the insulating films 50a, 50b of the n⁻-type SiC drive layer portions 42a, 42b is inverted to p-type SiC, and the body layer 53 and JTE layer 48a, as well as the body layer 54 and JTE layer 48b, enter states equivalent to being respectively electrically connected. A portion far from the surface is depleted. As a result, electric field concentration in the drift layer portions 42a, 42b is relaxed, and a high withstand voltage is obtained.

For purposes of comparison with the SiC MOSFET of this embodiment, a MOSFET was trial-fabricated and tested in which, in the configuration of Fig. 4, the source electrodes 73, 74 were not formed to outside the dashed lines 73a, 74a in the figure, and were not opposed to the drift layer portions 42a, 42b. As a result, the withstand voltage when a forward-direction voltage was applied across the source terminal 80 and drain electrode 79 was 2300 V. This withstand voltage was 1350 V lower than the value of 3650 V for the MOSFET of this embodiment.

A three-phase inverter, employed as a power supply device and configured using the SiC MOSFET of this embodiment, is explained below. Fig. 5 is the circuit diagram of a well-known inverter which converts the DC input from a DC power supply 96 into a three-phase AC output. The six switching devices 98 are SiC MOSFETs of this embodiment. The drain electrodes 79 of each of the switching devices 98a, 98b, 98c are connected to the positive terminal of the DC power supply 96, and the source terminals 80 are connected to the drain electrodes 79 of the switching devices 98d, 98e, 98f. The switching The source terminals 80 of the switching devices 98d, 98e, 98f are connected to the negative terminal of the DC power supply 96. The gate terminals 90 are connected to a well-known control circuit, omitted from the drawing. Three output lines 97 are drawn from the source terminals 80 of the switching devices 98a, 98b, 98c.

In the SiC MOSFETs of this embodiment, shown in Fig. 4, a PIN diode (hereafter called an internal diode) is formed by the pn junctions between the body layers 51 to 54, the drift layer 42, and the substrate 41 serving as the cathode. As indicated by the PIN diodes 99 in Fig. 5, these internal diodes are effectively connected inversely in parallel to MOSFETs. Hence the internal diodes function as flywheel diodes.

When the inverter shown in Fig. 5 is operating, the switching devices 98a to 98f undergo on-off operation, known in advance, each with prescribed timing under the control of the control circuit. As a result, forward-direction current flows with the respective timing in the diodes 99 functioning as flywheel diodes. The current flowing in the forward direction in the diodes 99 flows, in the SiC MOSFETs shown in Fig. 4, through the internal diodes formed by the source electrodes 71 to 74, body layers 51 to 54, junctions 75a and 75b, and drain electrode 79, from the source terminal 80 toward the drain electrode 79.

In the SiC MOSFETs of this embodiment comprised by the inverter shown in Fig. 5, upon causing operation for 100 hours in a state in which the current density peak value was 100 A/cm², the forward-direction voltage of 4.4 V immediately after the start of operation increased to 4.9 V after 100 hours of operation, so that only slight forward-direction voltage degradation occurred. This forward-direction voltage degradation is due to stacking faults occurring in the PIN diodes 99 acting as flywheel diodes during inverter operation, that is, in the drift layers 42 in internal diodes due to current flowing in the internal diodes of Fig. 4.

Conventionally configured SiC MOSFETs with a configuration similar to that of Fig. 4, with the left edge of the JTE layer 48a extended and connected to the body layer 53 and with the right edge of the JTE layer 48b extended and connected to the body layer 54, were trial-fabricated and were used in an inverter configured as in Fig. 5, and the forward-direction voltage was measured under the same conditions as in this embodiment. As a result, the forward-direction voltage, which had been 4.4 V immediately after the start of operation, rose to 10.5 V after operation for 100 hours. This 10.5 V forward-direction voltage is 5.6 V higher than the 4.9 V for a SiC-MOSFET of this invention. In the configuration of the trial-fabricated device, the body layer 53 and JTE layer 48a are connected, and moreover the body layer 54 and JTE layer 48b are connected, so that the forward-direction current flows through the drift layer 42 between the body layers 51 to 54 and JTE layers 48a and 48b, and the substrate 41. Consequently in the drift layer 42 between the JTE layers 48a and 48b, which were formed by ion implantation and have numerous crystal defects, and the substrate 41, stacking faults occurring during current passage grow and expand over the entirety of the drift layer 42, comprising internal diodes, and forward-direction voltage degradation advances. This occurs because during inverter operation the current flowing in the PIN diodes 99, which are flywheel diodes, cause stacking faults to grow and expand in the drift layer 42, and also because the growth and expansion of stacking faults due to current flowing in the JTE layers 48a, 48b as described above overlaps, so that considerable forward-direction voltage degradation occurs. As a result, during inverter operation the losses of internal diodes increase, and in addition these loss increases cause the device temperature to rise, entailing increases in the turn-on resistance in the MOSFET, so that inverter power losses increase dramatically.

As the flywheel diodes in the inverter circuit of Fig. 5, external diodes reverse-parallel connected to switching devices 98 (Schottky diodes and PIN diodes) may be connected (not shown in the figure). In this case, the internal resistance of the external Schottky diode or PIN diode is lower than that of the MOSFET internal diodes, and so the reverse current flowing through the internal diodes decreases. The reverse current flowing in the SiC MOSFET decreases, and so growth of stacking faults can be reduced. In this case also, similar degradation occurred, although the degree of degradation was slight. This is because when the inverter is driven at high current density, a portion of the current flows to internal diodes of other SiC MOSFETs in addition to external diodes, so that forward-direction voltage degradation occurs.

As described above, according to this embodiment when the forward-bias voltage of a SiC MOSFET is high, due to the field effect imparted by the source electrodes 73, 74 through the insulating films 50a, 50b, which are surface-protection films, the body layers 53, 54 are electrically connected with the JTE layers 48a, 48b, but when the forward-bias voltage is small, they are electrically separated, and current does not flow through the JTE layers 48a, 48b. By this means, degradation of the forward-direction voltage of flywheel diodes during inverter operation can be reduced, while maintaining a high withstand voltage, increases in device losses can be suppressed, and both high reliability and a high withstand voltage can be realized simultaneously.

In the above, embodiments of wide-gap semiconductor devices of this invention have been explained in detail; but this invention is not limited to the above embodiments. The impurity concentrations of various portions of the semiconductor devices, and the thicknesses and other dimensions of the various portions, can be modified so as to satisfactorily attain the functions of the portions. Application is also possible to various wide-gap bipolar semiconductor devices, such as for example semiconductor devices similar to those of the various embodiments but with opposite polarity (for example, pnp transistors rather than npn transistors). As examples, IGBTs, SIAFETs, SIJFETs, thyristors, GTOs, MCTs (MOS Controlled Thyristors), SiCGTs (SiC Commutated Gate Thyristors), ESTs (Emitter Switched Thyristors), BRTs (Base Resistance controlled Thyristors), and various other SiC bipolar switching semiconductor devices, as well as high-withstand voltage SiC light-emitting diodes, high-withstand voltage SiC semiconductor lasers, and other modified applications are possible.

This invention can also be applied in modified form to JFETs, SITs, and other wide-gap semiconductor switching devices, which are wide-gap semiconductor devices comprising portions which operate as bipolar semiconductor devices such as a MOSFET having a portion which operates as a bipolar semiconductor device, as described in the fourth embodiment, as well as to MPS (Merged PIN/Schottky) diodes, JBS (Junction Barrier controlled Schottky) diode devices, and similar.

This invention can also be applied to wide-gap semiconductor devices, high-withstand voltage wide-gap semiconductor light-emitting diodes, high-withstand voltage wide-gap semiconductor lasers and similar, comprising a bipolar semiconductor device operation portion, formed from wide-gap semiconductors other than SiC such as GaN or diamond. In the above fourth embodiment, an example of application to an inverter of SiC MOSFETs which are wide-gap semiconductor devices of this invention, was described; but wide-gap semiconductor devices of this invention can also be applied to switching power supply devices, high-power high-frequency oscillator devices, power amplifiers, and other power equipment.

Although not mentioned in the third or fourth embodiments, in each of these embodiments a p⁺ contact layer and Ohmic contact layer may be provided between the first electrode and the anode layer as necessary. Further, a space portion may be provided between the Ohmic contact layer and the oxide film for surface protection, and a portion for direct contact with the anode and a stopper material to impede intrusion of Ohmic contact layer formation material may be provided in the space portion, such that the Ohmic contact layer does not intrude into the interface between the oxide film for surface protection and the wide-gap semiconductor.

### INDUSTRIAL APPLICABILITY

This invention can be employed in wide-gap semiconductor devices and power devices for which a high withstand voltage and high reliability are required.

## Claims

1. A wide-gap semiconductor device, comprising:
a first pn junction formed by p-type and n-type semiconductor regions which operate as a bipolar semiconductor device, and forming a current path in the semiconductor regions;
an electric field relaxation layer provided within one of the semiconductor regions so as to be separated to an edge of the first pn junction, having a conduction type different from that of the one of the semiconductor regions, and forming a second pn junction with the one of the semiconductor regions surrounding thereof;
a first electrode electrically connected to the other of the semiconductor regions forming the first pn junction, opposed the one of the semiconductor regions between the first and second pn junctions with an electrical insulation film being intervening, and functioning as a current passage of the bipolar semiconductor device; and
a second electrode connected to the one of the semiconductor regions.

2. A wide-gap semiconductor device, comprising:
a first pn junction formed by p-type and n-type semiconductor regions which operate as a bipolar semiconductor device, and forming a current path in the semiconductor regions;
an electric field relaxation layer provided within one of the semiconductor regions so as to be separated to an edge of the first pn junction, having a conduction type different from that of the one of the semiconductor regions, and forming a second pn junction with the one of the semiconductor regions surrounding thereof;
a first electrode electrically connected to the other of the semiconductor regions forming the first pn junction, opposed the one of the semiconductor regions between the first pn and second junctions with an electrical insulation film being intervening, and functioning as a current passage of the bipolar semiconductor device; and
a second electrode connected to the one of the semiconductor regions,
wherein application of a voltage between the first electrode and the semiconductor regions so as to generate a depletion layer in the one of the semiconductor regions including the first pn junction causes that the first electrode imparts an electric field effect to the one of the semiconductor regions between the first and second pn junctions via the electrical insulation film, thereby the first and second pn junctions being electrically connected.

3. The wide-gap semiconductor device according to claim 1 or 2, wherein one semiconductor layer and the other semiconductor layer forms a mesa structure, the one semiconductor layer having a first conduction type which is any one of the p-type and n-type, and the other semiconductor layer having a second conduction type which is the other of the p-type and n-type and forming the first pn junction with the one semiconductor layer,
wherein the electric field relaxation layer is formed in the one semiconductor layer having the first conduction type so as to be separated from the first pn junction, and has the second conduction type,
wherein the first electrode is opposed to the one semiconductor layer between the first pn junction and the electric field relaxation layer with the electric insulation layer intervening, and is connected to the other semiconductor layer of the mesa structure, and
wherein the second electrode is connected to the one semiconductor layer having the first conduction type.

4. The wide-gap semiconductor device according to claim 1 or 2, wherein one semiconductor layer and the other semiconductor layer forms a planar structure, the one semiconductor layer having a first conduction type which is any one of the p-type and n-type, and the other semiconductor layer having a second conduction type which is the other of the p-type and n-type and forming the first pn junction with the one semiconductor layer,
wherein the electric field relaxation layer is formed in the one semiconductor layer having the first conduction type so as to be separated from the first pn junction, and has the second conduction type,
wherein the first electrode is opposed to the one semiconductor layer between the first pn junction and the electric field relaxation layer with the electric insulation layer intervening, and is connected to the other semiconductor layer of the planar structure, and
wherein the second electrode is connected to the one semiconductor layer having the first conduction type.

5. A wide-gap semiconductor device, comprising:
a first pn junction formed by p-type and n-type semiconductor regions which operate as a bipolar semiconductor device, and forming a current path in the semiconductor regions;
an electric field relaxation layer provided within a second semiconductor region of the semiconductor regions forming the first pn junction so as to be separated to an edge of the first pn junction, having a conduction type different from that of the second semiconductor region, and forming a second pn junction with the second semiconductor region;
at least one third semiconductor region formed on a first semiconductor region of the semiconductor regions forming the first pn junction, and having a conduction type different from that of the first semiconductor region;
a first electrode electrically connected to the third semiconductor region, and having an edge which is opposed to the second semiconductor region between the first and second pn junctions with an electrical insulation film being intervening;
a second electrode electrically connected to the first semiconductor region forming the first pn junction;
a fourth semiconductor region provided on one face of the second semiconductor region opposed to the other face of the second semiconductor region in which the first pn junction is provided, and having a conduction type different from that of the second conduction region; and
a third electrode provided on the fourth semiconductor region.

6. A wide-gap semiconductor device, comprising:
at least two first pn junctions, each of which is formed by p-type and n-type semiconductor regions operating as a bipolar semiconductor device and forms a current path in the semiconductor regions;
an electric field relaxation layer provided within a first semiconductor region of the semiconductor regions forming the first pn junction so as to be separated to an edge of the first pn junction, having a conduction type different from that of the first semiconductor region, and forming a second pn junction with the first semiconductor region;
at least one third semiconductor region formed in a second semiconductor region of the semiconductor regions forming the first pn junction, and having a conduction type different from that of the second semiconductor region;
a first electrode electrically connected to the third semiconductor region, and having an edge which is opposed to the semiconductor region between the first and second pn junctions with an electrical insulation film being intervening;
a second electrode electrically connected to a fourth semiconductor region which is the other of the semiconductor regions forming the first pn junction;
at least two third electrodes each of which is opposed to the semiconductor regions between the at least two first pn junctions with a insulation film being intervening; and
a fourth electrode connected to the fourth semiconductor region.

7. The wide-gap semiconductor device according to any one of claims 1 to 6 further comprising an ohmic contact layer provided between the fist electrode and the semiconductor region electrically connected to the first electrode,
wherein the insulation film is provided on a face of the semiconductor region so that a prescribed opening is kept between the insulation film and an edge of the ohmic contact layer.

8. The wide-gap semiconductor device according to claim 7, wherein the first electrode has a protruding portion formed so as to enter into the opening.

9. The wide-gap semiconductor device according to any one of claims 1 through 8, wherein the first electrode opposed to the semiconductor regions between the first and second pn junctions with the electrical insulation film being intervening is extended so as to overlap by a prescribed distance with the electric field relaxation layer forming the second pn junction with the electrical insulation film being intervening.

10. The wide-gap semiconductor device according to claim 7, wherein an insertion member made of a material which is hardly likely to react with a metal material of the ohmic contact layer is provided in the opening.

11. A power device, comprising a wide-gap semiconductor device as a control device,
wherein the wide-gap semiconductor device comprises:
at least two first pn junctions, each of which is formed by p-type and n-type semiconductor regions operating as a bipolar semiconductor device and forms a current path in the semiconductor regions;
an electric field relaxation layer provided within a first semiconductor region of the semiconductor regions forming the first pn junction so as to be separated to an edge of the first pn junction, having a conduction type different from that of the first semiconductor region, and forming a second pn junction with the first semiconductor region;
at least one third semiconductor region formed in a second semiconductor region of the semiconductor regions forming the first pn junction, and having a conduction type different from that of the second semiconductor region;
a first electrode electrically connected to the third semiconductor region, and having an edge which is opposed to the semiconductor region between the first and second pn junctions with an electrical insulation film being intervening;
a second electrode electrically connected to a fourth semiconductor region which is the other of the semiconductor regions forming the first pn junction;
at least two third electrodes each of which is opposed to the semiconductor regions between the at least two first pn junctions with a insulation film being intervening; and
a fourth electrode connected to the fourth semiconductor region.
